# EUROPEAN PATENT APPLICATION

(11) **EP 1 775 605 A1**
(43) Date of publication of application: **18.04.2007**
(21) Application number: 06291580.6
(22) Date of filing: 10.10.2006
(51) Int. Cl.: G02B 5/20, G02B 1/11, G06F 1/18, H05K 9/00

(54) **Display filter and plasma display apparatus**

(30) Priority: 11.10.2005 KR 20050095514
(71) Applicant: LG Electronics Inc., Seoul 150-721 (KR)
(72) Inventor: Shin, Woonseo, Gunpo-si, Gyenggi-do (KR)
(74) Representative: Vignesoult, Serge L. M.

(57) **Abstract**

A display filter and a plasma display apparatus are disclosed. The plasma display apparatus includes a plasma display panel, a display filter formed on the plasma display panel, and a ground member. The display filter includes an electromagnetic interference shielding layer, one or more films contacting the electromagnetic interference shielding layer, and a conductive layer filled in a through hole formed in the one or more films. The ground member is connected to the conductive layer. The diameter of the through hole ranges from 1 mm to 5 mm.

## Description

### BACKGROUND

### Field

This document relates to a display filter and a plasma display apparatus.

### Description of the Related Art

A plasma display apparatus comprises a plasma display panel in which a discharge cell is filled with a main discharge gas and an inert gas, and a driver. When a high frequency voltage is supplied to an electrode of the plasma display panel, the inert gas generates vacuum ultraviolet rays, which thereby cause a phosphor formed between barrier ribs of the plasma display panel to emit light.

The plasma display apparatus displays an image during each of subfields constituting a frame. Each of the subfields comprises a reset period for initializing all the discharge cells, an address period for selecting cells to be discharged and a sustain period for representing gray level in accordance with the number of discharges.

The reset period comprises a setup period and a set-down period. During the setup period, a setup pulse is supplied to scan electrodes. The setup pulse generates a weak dark discharge in the discharge cells. This results in wall charges of a positive polarity being accumulated on address electrodes and sustain electrodes, and wall charges of a negative polarity being accumulated on the scan electrodes.

During the set-down period, a set-down pulse is supplied to the scan electrodes. This results in erasing a portion of the wall charges excessively accumulated on the scan electrodes such the remaining wall charges are uniform inside the discharge cells.

During the address period, a scan pulse is supplied to the scan electrodes, and a data pulse is supplied to the address electrodes. As the voltage difference between the scan pulse and the data pulse is added to the wall voltage produced during the reset period, the cells to be discharged are selected.

During the sustain period, a sustain pulse is supplied to the scan electrodes and the sustain electrodes. A sustain discharge occurs within the discharge cells selected during the address period, thereby displaying an image.

The driver of the plasma display apparatus supplies a driving pulse to the electrode of the plasma display panel during the reset period, the address period and the sustain period. In other words, the driver supplies the setup pulse and the set-down pulse during the reset period, the data pulse and the scan pulse during the address period, and the sustain pulse during the sustain period.

Since the plasma display apparatus displays the image using the high frequency voltage for generating the plasma discharge, an electromagnetic wave is emitted from the front surface of the plasma display panel. Further, the plasma display apparatus emits near-infrared rays by the inert gas. The plasma display apparatus comprises a display filter for reducing or removing the electromagnetic wave emitted from the plasma display panel or the near-infrared rays.

### SUMMARY

In one aspect, a display filter comprises an electromagnetic interference shielding layer, one or more films contacting the electromagnetic interference shielding layer, and a conductive layer filled in a through hole formed in the one or more films.

In another aspect, a plasma display apparatus comprises a plasma display panel, a display filter, formed on the plasma display panel, comprising an electromagnetic interference shielding layer, one or more films contacting the electromagnetic interference shielding layer, and a conductive layer filled in a through hole formed in the one or more films, and a ground member connected to the conductive layer.

In still another aspect, a display filter comprises an electromagnetic interference shielding layer, and one or more films contacting the electromagnetic interference shielding layer and having a through hole.

### BRIEF DESCRIPTION OF THE DRAWINGS

The accompany drawings, which are included to provide a further understanding of the invention and are incorporated on and constitute a part of this specification illustrate embodiments of the invention and together with the description serve to explain the principles of the invention.

FIG. 1 illustrates a plasma display apparatus according to a first embodiment;

FIG. 2 is a plane view of a display filter according to the first embodiment;

FIG. 3 is a cross-sectional view of the display filter according to the first embodiment;

FIG. 4 illustrates a plasma display apparatus according to a second embodiment;

FIG. 5 illustrates a plasma display apparatus according to a third embodiment;

FIG. 6 illustrates the display filter and a ground member in the plasma display apparatus according to the first embodiment; and

FIG. 7 illustrates a plasma display apparatus according to a fourth embodiment.

### DETAILED DESCRIPTION OF PREFERRED EMBODIMENTS

Preferred embodiments of the present invention will be described in a more detailed manner with reference to the drawings.

A display filter comprises an electromagnetic interference shielding layer, one or more films contacting the electromagnetic interference shielding layer, and a conductive layer filled in a through hole formed in the one or more films.

The one or more films may be formed on the electromagnetic interference shielding layer.

The display filter may comprise a film filter.

The one or more films may be an anti-reflection layer.

The display filter may further comprise an anti-reflection layer.

The through hole may be formed in a partial area of the one or more films which does not overlap the anti-reflection layer.

The conductive layer may comprise silver or copper.

The electromagnetic interference shielding layer may comprise a mesh portion.

The display filter may further comprise a near-infrared ray shielding layer.

The display filter may further comprise a color correction layer.

The display filter may further comprise a layer having both a near-infrared ray shielding function and a color correction function.

The diameter of the through hole may range from 1 mm to 5 mm.

The length of the through hole may be equal to or less than the length of the conductive layer.

A plasma display apparatus comprises a plasma display panel, a display filter, formed on the plasma display panel, comprising an electromagnetic interference shielding layer, one or more films contacting the electromagnetic interference shielding layer, and a conductive layer filled in a through hole formed in the one or more films, and a ground member connected to the conductive layer.

The ground member may comprise a finger spring.

The ground member may comprise an anisotropic conductive film or a conductive adhesive.

The display filter may further comprise an anti-reflection layer.

The through hole may be formed in a partial area of the one or more films which does not overlap the anti-reflection layer.

The diameter of the through hole may range from 1 mm to 5 mm.

A display filter comprises an electromagnetic interference shielding layer, and one or more films contacting the electromagnetic interference shielding layer and having a through hole.

The diameter of the through hole may range from 1 mm to 5 mm.

Hereinafter, exemplary embodiments of the present invention will be described in detail with reference to the attached drawings.

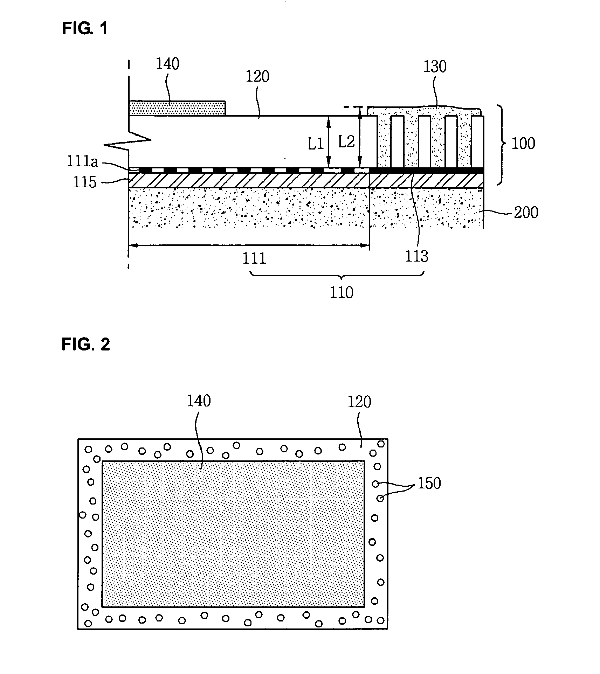

FIG. 1 illustrates a plasma display apparatus according to a first embodiment. As illustrated in FIG. 1, the plasma display apparatus according to the first embodiment comprises a display filter 100 and a plasma display panel 200. The display filter 100 is disposed on an upper surface of the plasma display panel 200. The display filter 100 of the plasma display apparatus according to the first embodiment comprises a film filter.

The display filter 100 comprises an electromagnetic interference shielding layer 110, one or more films 120 contacting the electromagnetic interference shielding layer 110, a conductive layer 130 filled in a through hole formed in the one or more films 120, and an anti-reflection layer 140 formed on the one or more films 120. While the conductive layer 130 is formed in one or more films 120 in FIG. 1, the conductive layer 130 may be formed in a plurality of films which are laminated one another. The through hole passes from an upper surface to a lower surface of the film 120.

The one or more films 120 are made of a material capable of transmitting light. Examples of the material capable of transmitting light include cellulose-based resin such as polyethylene terephthalate, polyethersulfone, polystyrene, polyethylene naphthalate, polyaryllate, polyetheretherketone, polycarbonate, polyethylene, polypropylene, polyamide, polyimide, triacetylcellulose, fluorine-based resin such as polyurethane, polytetrafluoroethylene, vinyl compound such as polyvinyl chloride, polyacrylate, polymethacrylate or copolymer thereof

The thickness of the one or more films 120 may range from 75 µm to 150 µm. When the plurality of films are laminated, the total thickness of the laminated films may range from 75 µm to 150 µm. When the thickness of the one or more films 120 ranges from 75 µm to 150 µm, the display filter 100 has strength and flexibility to the extent that the display filter 100 can be formed on the plasma display panel 200.

The electromagnetic interference shielding layer 110 may comprise a metal with high conductivity such as silver (Ag) or copper (Cu). The electromagnetic interference shielding layer 110 may be a mesh type shielding layer or a conductive layer type shielding layer. The mesh type shielding layer comprises a mesh portion 111 having a conductive mesh and a metal frame 113 surrounding an outer area of the mesh portion 111. The metal frame 113 of the mesh type shielding layer surrounds the outer area of the mesh portion 111, thereby supporting the mesh portion 111. The metal frame 113 is electrically connected to the conductive layer 130 filled in the through hole. The mesh portion 111 secures transmissivity of light emitted from the plasma display panel 200, and absorbs an electromagnetic wave. The electromagnetic interference shielding layer 110 may comprise only the mesh portion. In such a case, the conductive mesh of the mesh portion may contact the conductive layer 130.

The electromagnetic interference shielding layer 110 may be formed using a sputtering method, an electrolytic plating method, an electroless plating method, and the like. A method for forming a copper layer using the electroless plating method comprises adhering metal catalyst for accelerating metal crystal growth on a film 115, and immersing the film 115 in a plating solution including copper salt, a reducing agent, a complexing agent, a pH control agent, a pH buffer agent and an improvement agent.

The metal catalyst comprises silver (Ag) or palladium (Pd). The copper salt functions as the supplying of copper ions to the film 115. For example, the copper salt may comprise Ag-Cu chloride, nitrates, sulfate. The reducing agent functions as the reduction of metal ions on the film 115. The reducing agent comprises polysaccharide compound such as NaBH₄, KBH₄, hydrazine, formalin or glucose. The complexing agent prevents the precipitation of hydroxide in an alkaline solution, and controls a concentration of free metal ions, thereby preventing the decomposition of metal salt and controlling a plating speed. The complexing agent comprises a chelate agent such as an ammonia solution, acetic acid, guanine acid, stannate, EDTA, or an organic amine compound. The pH control agent controls pH of the plating solution. The pH control agent comprises an acid compound or a base compound. The pH buffer agent prevents a change in pH, and comprises various organic acids or a weak acid inorganic compound. The improvement agent improves a coating characteristic and a planarization characteristic. The improvement agent comprises surfactant or an adsorbent material capable of adsorbing a component for interrupting the crystal growth.

A method for forming a silver layer using the electroless plating method comprises immersing the film 115 in a plating solution including a silver salt, a reducing agent, a complexing agent, a pH control agent, a pH buffer agent and an improvement agent. Components and functions of the components of the plating solution were described above.

When a metal layer is formed on an upper surface of the film, a photoresist pattern of the conductive mesh is formed on the metal layer using a photolithography process. Then, the metal layer is etched using the photoresist pattern of the conductive mesh as a mask, thereby forming the mesh portion 111 and the metal frame 113.

The mesh portion 111 comprises a conductive mesh 111a having the cross structure. The mesh portion 111 has holes inclined to a bias angle capable of transmitting visible light by the conductive mesh 111a. The bias angle may vary depending on definition of the plasma display panel 200.

The anti-reflection layer 140 may have refractive index equal to or less than 1.5 in a visible region. For example, the anti-reflection layer 140 may have refractive index equal to or less than 1.4, and may be formed of fluorine-based transparent polymer resin being a single layer, silicon-based resin, a silicon oxide thin film, and the like. Further, the anti-reflection layer 140 may be formed by laminating a layer with high refractive index and a layer with low refractive index. The layer with high refractive index and the layer with low refractive index each comprise an inorganic compound such as a metal oxide, fluoride, silicide, boride, carbide, nitride, sulfide, or an organic compound such as silicon-based resin, acrylic-based resin.

The anti-reflection layer being a single layer is easy to be manufactured. The anti-reflection layer being a plurality of layers has an excellent anti-reflection property, and also has an anti-reflection property throughout a wide wavelength area. Further, the anti-reflection layer of the plurality of layers is slightly affected by an optical design by an optical characteristic of a film. The anti-reflection layer 140 of the plurality of layers may have visible light reflectivity of 2%.

Since the anti-reflection layer 140 is exposed to the outside, the anti-reflection layer 140 may comprise a hard coating layer. The hard coating layer may be formed of thermosetting resin or photo-crosslinked resin such as acrylic-based resin, silicon-based resin, melamine-based resin, urethane-based resin, fluorine-based resin.

The anti-reflection layer 140 prevents a glare phenomenon generated by reflecting visible light from the outside on the surface of the plasma display panel 200, thereby improving contrast and color purity of the plasma display panel 200.

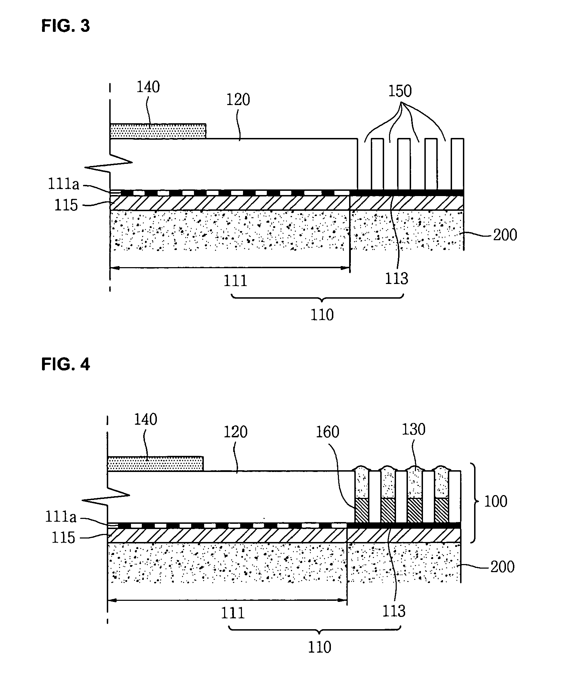

FIG. 2 is a plane view of a display filter according to the first embodiment. FIG. 3 is a cross-sectional view of the display filter according to the first embodiment. The through hole 150 formed in the one ore more films 120 is a space filled with the conductive layer 130 for electrically connecting the electromagnetic interference shielding layer 110 to a ground member (not illustrated). The diameter of the through hole may range from 1 mm to 5 mm. When the diameter of the through hole 150 ranges from 1 mm to 5 mm, it is easy to fill the through hole 150 with the conductive layer 130, and the through hole 150 does not interrupt the formation of the electromagnetic interference shielding layer 110. As illustrated in FIGs. 2 and 3, the through hole 150 may be formed at an edge of the film 120, i.e., in a partial area of the film 120 where the anti-reflection layer 140 is not formed. Accordingly, a length L1 of the through hole 150 may be equal to or less than a length L2 of the conductive layer 130.

As illustrated in FIG. 1, the conductive layer 130 filled in the through hole 140 may comprise silver or copper. To stably ground using the conductive layer 130, the conductive layer 130 may be formed inside and outside the through hole 150, i.e., on an upper surface of the film 120. The conductive layer 130 may be filled using a method of coating a metal paste or a plating method.

FIG. 4 illustrates a plasma display apparatus according to a second embodiment. As illustrated in FIG. 4, before filling a through hole 150 with a conductive layer 130, a growth nucleus 160 is formed inside the through hole 150.

When the through hole 150 is previously formed before forming an electromagnetic interference shielding layer 110, the growth nucleus 160 is formed on the electromagnetic interference shielding layer 110 using a method such as a screen printing method, and a portion of the inside of the through hole 150 is filled with the growth nucleus 160 in a combination process of the electromagnetic interference shielding layer 110 and a film 120. When the portion of the inside of the through hole 150 is filled with the growth nucleus 160, the formation of the conductive layer 130 using a plating method can be carried out rapidly by the growth nucleus 160.

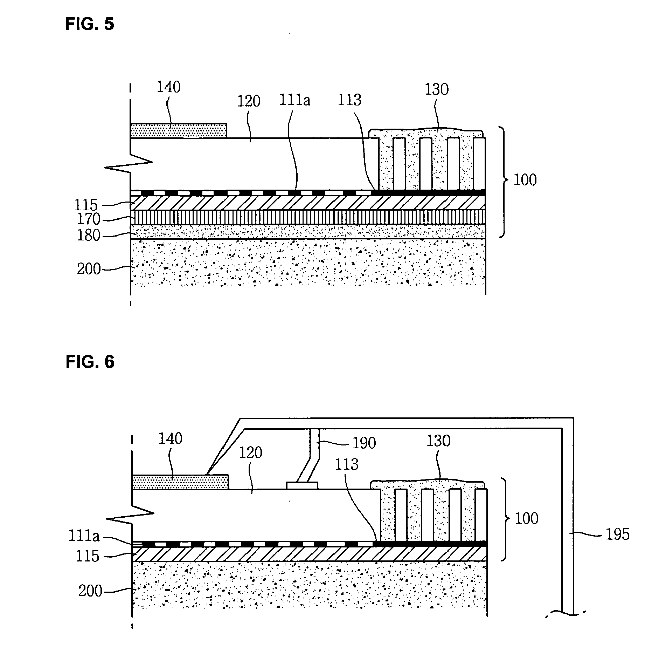

FIG. 5 illustrates a plasma display apparatus according to a third embodiment. As illustrated in FIG. 5, the plasma display apparatus according to the third embodiment may further comprise at least one of a near-infrared ray shielding layer 170 or a color correction layer 180.

The near-infrared ray shielding layer 170 absorbs near-infrared rays having a wavelength of 800-1,000 nm generated in a plasma display panel 200, thereby normally inputting control infrared rays generated in a remote controller, and the like, of the plasma display apparatus to an infrared ray receiving unit (not illustrated) without the interference of the near-infrared rays.

The color correction layer 180 comprises a color control dye, thereby improving color purity of the plasma display apparatus. When the near-infrared ray shielding layer has a color correction function, the color correction layer may be omitted.

In FIG. 5, the laminating order of an anti-reflection layer 140, the near-infrared ray shielding layer 170 and the color correction layer 180 may change. For example, the anti-reflection layer 140 may formed under an electromagnetic interference shielding layer 110. Further, the electromagnetic interference shielding layer 110, the color correction layer 180 and the near-infrared ray shielding layer 170 may be laminated in the order named.

FIG. 6 illustrates the display filter and a ground member in the plasma display apparatus according to the first embodiment. As illustrated in FIG. 6, a ground member 190 electrically connects the conductive layer 130 to a case 195 of the plasma display apparatus. The ground member 190 may comprise a finger spring. Further, the ground member 190 may comprise a finger spring, or an anisotropic conductive film or a conductive adhesive instead of the finger spring.

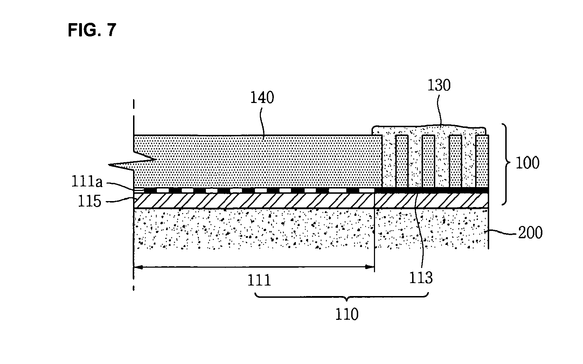

FIG. 7 illustrates a plasma display apparatus according to a fourth embodiment. As illustrated in FIG. 7, the plasma display apparatus according to the fourth embodiment comprises an anti-reflection layer 140 having a through hole. On the other hand, the through hole 150 illustrated in FIG. 1 is formed in the one ore more films 120 provided separately from the anti-reflection layer 140. In other words, the through hole according to the fourth embodiment is formed in the anti-reflection layer 140, and the inside of the through hole is filled with a conductive layer 130. The conductive layer 130 contacts an electromagnetic interference shielding layer 110.

The embodiments provide the simple ground structure by filling the through hole with the conductive layer.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures. Moreover, unless the term "means" is explicitly recited in a limitation of the claims, such limitation is not intended to be interpreted under 35 USC 112(6).

## Claims

1. A display filter comprising:
an electromagnetic interference shielding layer;
one or more films contacting the electromagnetic interference shielding layer; and
a conductive layer filled in a through hole formed in the one or more films.

2. The display filter of claim 1, wherein the one or more films are formed on the electromagnetic interference shielding layer.

3. The display filter of claim 1, wherein the display filter comprises a film filter.

4. The display filter of claim 1, wherein the one or more films are an anti-reflection layer.

5. The display filter of claim 1, further comprising an anti-reflection layer.

6. The display filter of claim 5, wherein the through hole is formed in a partial area of the one or more films which does not overlap the anti-reflection layer.

7. The display filter of claim 1, wherein the conductive layer comprises silver or copper.

8. The display filter of claim 1, wherein the electromagnetic interference shielding layer comprises a mesh portion.

9. The display filter of claim 1, further comprising a near-infrared ray shielding layer.

10. The display filter of claim 1, further comprising a color correction layer.

11. The display filter of claim 1, further comprising a layer having both a near-infrared ray shielding function and a color correction function.

12. The display filter of claim 1, wherein the diameter of the through hole ranges from 1 mm to 5 mm.

13. The display filter of claim 1, wherein the length of the through hole is equal to or less than the length of the conductive layer.

14. A plasma display apparatus comprising:
a plasma display panel;
a display filter, formed on the plasma display panel, comprising an electromagnetic interference shielding layer, one or more films contacting the electromagnetic interference shielding layer, and a conductive layer filled in a through hole formed in the one or more films;
and
a ground member connected to the conductive layer.

15. The plasma display apparatus of claim 14, wherein the ground member comprises a finger spring.

16. The plasma display apparatus of claim 14, wherein the ground member comprises an anisotropic conductive film or a conductive adhesive.

17. The plasma display apparatus of claim 14, wherein the display filter further comprises an anti-reflection layer.

18. The plasma display apparatus of claim 17, wherein the through hole is formed in a partial area of the one or more films which does not overlap the anti-reflection layer.

19. The plasma display apparatus of claim 14, wherein the diameter of the through hole ranges from 1 mm to 5 mm.

20. A display filter comprising:
an electromagnetic interference shielding layer, and
one or more films contacting the electromagnetic interference shielding layer and having a through hole.

21. The display filter of claim 20, wherein the diameter of the through hole ranges from 1 mm to 5 mm.
